# EUROPEAN PATENT APPLICATION

(11) **EP 2 701 214 A1**
(43) Date of publication of application: **26.02.2014**
(21) Application number: 11863926.9
(22) Date of filing: 20.04.2011
(51) Int. Cl.: H01L 33/50, H01L 33/54

(54) **LIGHT EMITTING DEVICE AND METHOD FOR MANUFACTURING SAME**

(71) Applicant: Elm Inc., Minamisatsuma-shi Kagoshima 897-1124 (JP)
(72) Inventor: INOUE Tomio, Minami-Satsuma-City Kagoshima 897-1124 (JP); MIYAHARA Takakazu, Minami-Satsuma-City Kagoshima 897-1124 (JP)
(74) Representative: White, Duncan Rohan
(86) International application number: PCT/JP2011/059719
(87) International publication number: WO 2012/144030

(57) **Abstract**

A light emitting device which is inexpensive and has excellent characteristics and a method for manufacturing the same are provided. In the present invention, a chip-size package including a reflection wall is formed by forming a double structure in which a fluorescent material-containing film piece 2 is bonded on a light extraction surface of a semiconductor light emitting element 6 having bumps 4 and 5 on an electrode-formed surface, and covering an exposed surface of the double structure other than a bump mounting surface 7 and a light exit surface 8 with the reflection wall 3, whereby it is possible to provide a light emitting device which does not need a package substrate, is inexpensive, and has excellent brightness characteristics and heat radiation characteristics, and a manufacturing method having excellent chromaticity yield.

## Description

### TECHNICAL FIELD

The present invention relates to a light emitting device for use in an LED lamp or the like and a method for manufacturing the same, and particularly relates to a light emitting device including a semiconductor light emitting element which emits blue light, purple light, or ultraviolet light, a fluorescent material layer which converts the light into white light, and a reflection wall which efficiently reflects the white light in a specific direction, and a method for manufacturing the same.

### BACKGROUND ART

In recent years, a lamp using an LED has been put to practical use and has been replacing an incandescent lamp and a fluorescent lamp. The reason is that with such a lamp, the same brightness is obtained with low power consumption, and thus such a lamp becomes a trump as an environmentally friendly product that allows great reduction in emissions of carbon dioxide which is a cause for global warming. For example, a 9-W LED bulb can achieve the same brightness as that of a 60-W incandescent lamp. As described above, if all lamps are replaced with LED lamps, it is possible to easily achieve the reduction targets of carbon dioxide emissions. This is prevented by a large price difference remaining between the two types of lamps. In view of life, the price difference is very small. Thus, lamps at special locations have been replaced with LED lamps, since it is also possible to reduce labor costs for replacing such lamps. However, spread of LED lamps to general lamps for which there is the most need is prevented since the initial price difference is still great.

The reasons for making an LED bulb expensive are roughly classified into two reasons. One reason is that the driving power supply of an LED bulb is a constant direct current power supply and thus a converter that performs conversion from an alternate current is needed. The other reason is that a light emitting device (white LED device) itself is expensive. The reasons for making a white LED device expensive are that the material cost is high and the yield is poor. The material cost of a white LED device is higher in order of a package, an LED chip, a fluorescent material, and a resin whose occupancies of the material cost are higher in order, and the main factor for deteriorating the yield of a white LED device is the yield regarding chromaticity (or color temperature) (i.e., an efficiency percentage at which target chromaticity is obtained is decreased due to variations of an amount of the fluorescent material, etc.). From this standpoint, each company that sells white LED devices is making efforts to decrease the price.

One example of the efforts is an effort of Cree, Inc. as described in Patent Literature 1. Hitherto, a light emitting device has been manufactured by mounting a semiconductor light emitting element (LED chip) on a package and then sealing the package with a resin in which fluorescent material powder is dispersed. With such a manufacturing method, when a light emitting device is determined as being not good in a chromaticity test, the entire light emitting device including the package is determined as being not good, and even the most-expensive package is discarded. In contrast, in Patent Literature 1, as shown in FIGS. 13(a) and 13(b), a white LED chip 130 is formed in which a fluorescent material layer is formed on a light extraction surface excluding wire bonding pads 131 of the LED chip (or including a side surface of the LED chip). In this case, it is possible to conduct the chromaticity test at the stage of chip, and thus an expensive package is no longer discarded. In addition, since the fluorescent material is used only in the range of a chip surface, the fluorescent material is saved. Furthermore, since chromaticity is determined at a point light source of the LED chip, variations of chromaticity depending on a viewing angle of a white LED device are also improved.

A similar effort is made in Patent Literature 2 and 3.

In Patent Literature 2, as shown in FIG. 14(a), a chip assembly 142 in which a fluorescent material chip 141 is bonded to an LED chip by a transparent resin is mounted on a package by a flip chip method. In another example, mounting is conducted by a wire bonding method (a method in which mounting is conducted with an electrode surface facing up, and connection with a substrate is made by means of wire bonding). In addition, in Patent Literature 3, as shown in FIG. 14(b), an LED chip having bumps 146 at a mounting portion (electrode portion), excluding bump end portions, is coated with a resin in which fluorescent material powder is dispersed, to form a structure 147, and the structure 147 is mounted in a cavity, at which a reflection wall 148 is provided, with a conductive adhesive applied to the bump portions and is sealed with a transparent resin. These two examples are also examples aimed at improvement similar to that in Patent Literature 1.

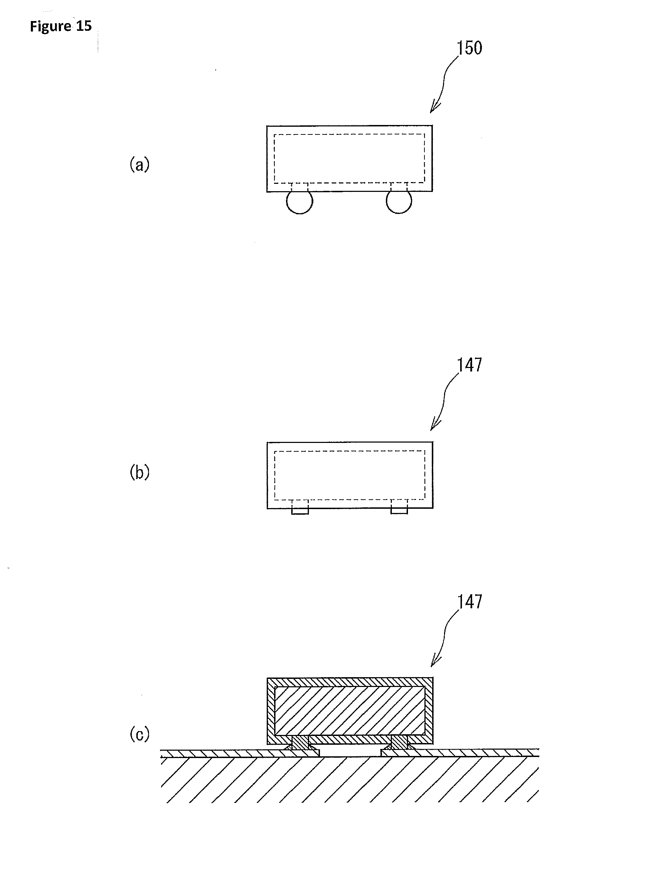

In addition, in the case of Patent Literature 3, the structure 147 has a structure similar to that of a semiconductor device (a semiconductor device 150 shown in FIG. 15(a)) described in Patent Literature 4 (a document regarding a semiconductor element, in particular, a chip-size package of an LSI chip), and is similar to one which will be discussed in the present invention. In other words, the structure 147 has, as a chip-size package structure, a structure which allows the structure 147 to be mounted directly on a wiring substrate as shown in FIG. 15(c) and allows omission of a package whose material cost is high. However, the light emitting device 147 with such a structure lacks an important characteristic required for an environmentally friendly lamp. This is that the light emitting device 147 has no light condensing function at all.

### CITATION LIST

### [PATENT LITERATURE]

| | |
|---|---|
| [PTL 1] | Japanese Laid-open Patent Publication No. 2010-517289 |
| [PTL 2] | Japanese Laid-open Patent Publication No. 2002-141559 |
| [PTL 3] | Japanese Laid-open Patent Publication No. 2002-261325 |
| [PTL 4] | Japanese Patent No. 3526731 |

### SUMMARY OF THE INVENTION

### PROBLEMS TO BE SOLVED BY THE INVENTION

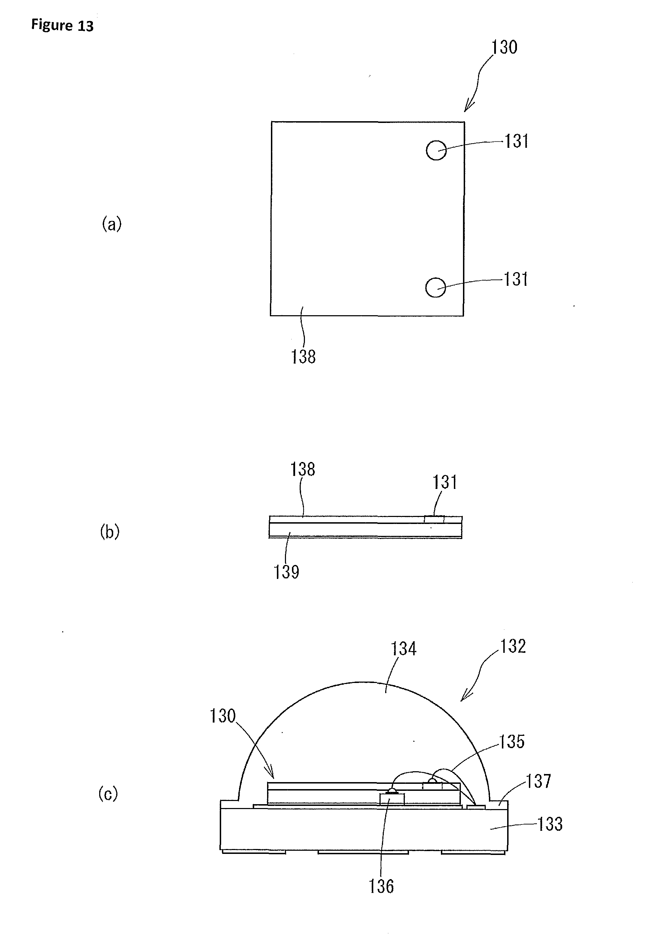

As described in Patent Literature 1, 2, and 3, a concept of a white light emitting element (a white LED chip) has been introduced for aiming at saving of the fluorescent material, improvement of the yield regarding chromaticity, and improvement of variations of chromaticity depending on a viewing angle by making a white point light emitter. As shown in FIG. 13(c), the white light emitting element 130 is mounted on a plate-shaped package substrate 133 (specifically, an alumina ceramic substrate) whose thermal conductivity is good to a medium degree, and is sealed with a resin lens 134, whereby a light emitting device 132 having a structure to condense light in an intended direction is produced at low cost and is establishing its structure as a light emitting device for illumination having desired brightness, heat radiation, and reliability. However, in the package that is most expensive due to the component configuration, on the basis of an idea that its characteristics are not impaired as much as possible and the package is made as cheap as possible, size reduction is made, and a structure of a reflection wall is eliminated and replaced with light condensing with the resin lens 134. However, the expensive package substrate 133 is still present, and the package substrate 133 itself also deteriorates the characteristics of the light emitting device for illumination more than a little.

In the case of FIG. 13(c), specifically, there are two major reasons that the package substrate (alumina ceramic substrate) cannot be eliminated. One reason is that since the white LED chip 130 is mounted by the wire bonding method, the package substrate 133 is required at any cost for mounting on a terminal of an external substrate by solder. The other reason is that in order to condense light of the white LED chip 130 in a specific direction, a reflection wall or a lens is required, and the package substrate 133 is required for forming it.

Regarding the former, when the mounting method is changed to a flip chip method and a chip-size package 147 shown in FIG. 15(b) is made as in Patent Literature 3, it is possible to omit a package substrate. However, the latter cannot be solved by the structure in FIG. 15(b). In other words, a function to condense light of a white light emitting element is not provided. From the standpoint of effective utilization of light, a function to direct light in a specific direction is an important factor for an environmentally friendly lamp. In addition, this function is more effective when its location is closer to a light-emitting source. In other words, it is more effective to dispose the reflection wall within the light emitting device than to dispose the reflection wall around the light emitting device and away from the light emitting device. Thus, a light condensing function is provided to the package within the light emitting device.

Next, the contents of the fact that the package substrate 133 shown in FIG. 13(c) deteriorates the characteristics of the light emitting device 132, will be specifically described.

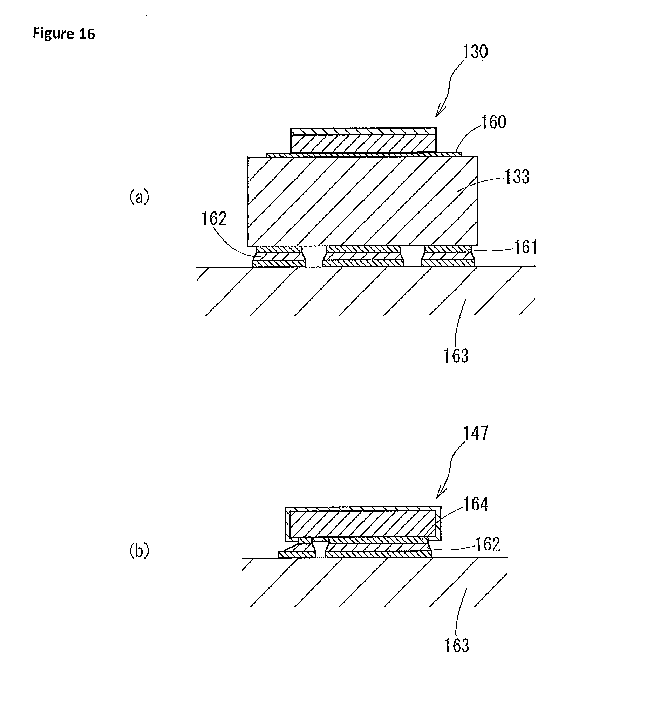

One content relates to heat radiation. Heat generated at a p-n junction of the 4-W white light emitting element 130 is transmitted from an anode electrode of the LED chip to an electrode 160 of the package substrate 133 thermally welded thereto and is further transmitted through many layers such as the alumina ceramic substrate 133, an electrode 161, a solder 162 to an external substrate 163 as shown in FIG. 16(a). In contrast, in the case of the chip-size package 147 shown in FIG. 15(b), heat generated at a p-n junction is transmitted directly to a bump 164, a solder 162, and an external substrate 163 as shown in FIG. 16(b), and a structure is basically configured in which heat radiation is improved. When a specific calculation is performed, the thermal resistance R of the alumina ceramic substrate 133 which is the difference between FIGS. 16(a) and 16(b) becomes R = 3.68°C/W where size: 3.56 mm square, thickness: 0.7 mm, and thermal conductivity: 16 W/m. K are used. In the case with a 4-W LED, the temperature is increased by 14.7°C due to this substrate.

Another content relates to the condensing resin lens 134 which condenses light in a specific direction. As shown in FIG. 13(c), in the resin lens 134, a portion 137 of a surface in contact with the package substrate 133 which portion 137 has a constant width (a thickness of about 50 µm) has a thin plate shape, not a lens shape. When light enters this portion, the light leaks laterally and cannot be effectively utilized. The occurrence of this portion 137 is attributed to the manufacturing method, and compression molding for molding a silicon resin lens cannot prevent occurrence of such a portion. In addition, this problem cannot be solved by the chip-size package 147 shown in FIG. 15(b), since the chip-size package 147 has no light condensing function at all.

The present invention has been made in view of the above-described situation, and, specifically, an object of the present invention is to provide a light emitting device for illumination which has improved characteristics and is inexpensive by providing a chip-size package structure in which a package substrate having a high occupancy of material cost is eliminated and which also has a function to condense light, emitted by a white light emitting element, in a specific direction with low loss in the form of a reflection wall, and a method for manufacturing the same.

### SOLUTION TO THE PROBLEMS

An invention according to a first aspect is a light emitting device wherein
on a semiconductor light emitting element which emits blue light, purple light, or ultraviolet light, has two opposed principal surfaces one of which is a light extraction surface and another of which is an electrode-formed surface, and has a bump on the electrode-formed surface, a fluorescent material-containing film piece which has two opposed principal surfaces each of which is the same in size as or larger in size than the light extraction surface, one of which is a light entrance surface, and another of which is a light exit surface is overlaid such that the light extraction surface is opposed to the light entrance surface, and
an exposed surface other than the electrode-formed surface of the semiconductor light emitting element (including a surface of the bump) and the light exit surface of the fluorescent material-containing film piece or an exposed surface other than the light exit surface of the fluorescent material-containing film piece and a surface of the bump at which the semiconductor light emitting element is mounted on an external substrate (hereinafter, referred to as a bump mounting surface) is covered with a reflection wall.

Most part of light emitted at a p-n junction of the semiconductor light emitting element exits through the light extraction surface and enters the fluorescent material-containing film piece through the light entrance surface of the fluorescent material-containing film piece overlaid on the light extraction surface, to cause the fluorescent material to emit light. The entirety of the light exits through the light exit surface and is used as white light for illumination.

In a method for obtaining white light for illumination using a semiconductor light emitting element, YAG fluorescent material powder which emits, from blue light, yellow light which has a complementary relationship with blue color is used in the early stage. However, the value of an average color rendering index Ra of pseudo white light produced by the blue light of the semiconductor light emitting element and the yellow light of the YAG fluorescent material is as low as about 78, and it is impossible to reproduce natural color of matter with this illumination. Thus, as a second step, powder of fluorescent materials which emit, from blue light, light of green and red which are two of the three primary colors of light is used, and white light composed of components of three primary colors of light is produced by the blue light of the semiconductor light emitting element and the green light and the red light from two types of the fluorescent materials. The value of an average color rendering index Ra of the white light is improved to 93, and color reproducibility by this illumination is also significantly improved. In addition, if the brightness of a semiconductor light emitting element which emits purple light or ultraviolet light is increased in the future, powder of three types of fluorescent materials which emit the three primary colors of light from purple light or ultraviolet light will be used. Moreover, a plurality of fluorescent materials may be mixed therein in order to improve color reproducibility. As described above, it is possible to produce intended white light for illumination by dispersing the above fluorescent material powder in the fluorescent material-containing film piece in accordance with the wavelength of light emitted by the semiconductor light emitting element.

With this structure, all the problems described above are solved. In other words, the following is achieved.

A white light emitting element is provided in which the fluorescent material-containing film piece is overlaid on the light extraction surface of the semiconductor light emitting element, and it is possible to save the fluorescent material, to improve yield regarding chromaticity, and to improve variations of chromaticity depending on a viewing angle due to a white point light emitter.

The surface other than the electrode-formed surface of the semiconductor light emitting element (preferably, the bump mounting surface) and the light exit surface of the fluorescent material-containing film piece is covered with the reflection wall, light traveling in a direction other than a direction toward the light exit surface (light traveling toward the electrode-formed surface of the semiconductor light emitting element, light traveling toward the side surface of the semiconductor light emitting element, light traveling toward the side surface of the fluorescent material-containing film piece, etc.) is efficiently reflected by the reflection wall (the light traveling toward the electrode-formed surface is reflected also by the electrode) and is less likely to exit the light emitting device. In other words, light is condensed by the reflection wall in a specific direction. In addition, a structure that is able to prevent light from leaking laterally is provided. Furthermore, the reflection wall is formed so as to be in close contact with a light source (namely, at the closest distance therefrom), and thus light is reflected and condensed most efficiently.

Since a chip-size package is provided in which the semiconductor light emitting element is mounted at its bump mounting surface on the external substrate, an expensive package substrate is not used. In addition, thus, heat is radiated from the semiconductor light emitting element directly to the bump, a solder, and the external substrate.

An invention according to a second aspect is the light emitting device according to the first aspect, wherein the semiconductor light emitting element and the fluorescent material-containing film piece are bonded to each other by a silicon resin or a silicon resin which contains a fluorescent material or a pigment for correcting chromaticity or color temperature.

The semiconductor light emitting element and the fluorescent material-containing film piece are overlaid and bonded to each other, and a highly reliable transparent resin which is less likely to be deteriorated and changed in color by light or heat is used as the adhesive. A resin which is most suitable for this purpose is a silicon resin. In addition, the chromaticity or color temperature of white light is determined by light of the semiconductor light emitting element and light from the fluorescent material-containing film piece, and variations of the chromaticity or color temperature occur since there are variations of the wavelength of the light of the semiconductor light emitting element and slight variations of the amount of the fluorescent material included in the fluorescent material-containing film piece. For the purpose of correcting this, a pigment or fluorescent material powder is mixed in the silicon resin for bonding, whereby the correction is possible.

An invention according to a third aspect is the light emitting device according to the first or second aspect, wherein a material of the fluorescent material-containing film piece is a material obtained by dispersing powder of several types of fluorescent materials in a silicon resin, and a material of the reflection wall is a material obtained by dispersing titanium oxide fine powder in a silicon resin.

The resin for dispersing the powder of several types of fluorescent materials is preferably a transparent resin which has a high refractive index, is not deteriorated or changed in color by light or heat, and has a Shore D hardness of not less than 60. A resin which is most suitable for this is a silicon resin (resin type silicone). In addition, the resin for dispersing the titanium oxide fine powder is also the same as that for the fluorescent material powder, but attention needs to be paid to the fact that titanium oxide has characteristics as a photocatalyst. In other words, when light (ultraviolet light, blue light, etc.) is applied to titanium oxide, a phenomenon is caused that titanium oxide decomposes the ambient moisture to produce an active radical which affects and changes a resin in color. Thus, even the silicon resin is changed in color in a short time (several tens of hours). In order to prevent this, sufficient attention is required for selection of titanium oxide, rutile is preferred rather than anatase as a crystalline structure, and titanium oxide fine powder whose surface is coated with silica or alumina or treated with siloxane is preferred. It is possible to suppress the photocatalyst effect by such treatment.

In addition, the thickness of the reflection wall needs to be a thickness sufficient to reflect light. The particle diameter of the titanium oxide fine particles is about 0.2 µm, and thus it is sufficient that the thickness of the reflection wall is about 50 to 100 times of the particle diameter. In other words, it suffices that the thickness of the reflection wall is equal to or larger than 10 µm. Thus, the height of the bump on the electrode-formed surface of the semiconductor light emitting element also needs to be equal to or higher than 10 µm, and preferably, the height of the bump needs to be equal to or higher than 15 µm in order to protrude the bump mounting surface from the reflection wall. However, since the metal electrode whose reflectance is also taken into consideration occupies a large portion of the electrode-formed surface, when the height of the bump is lower than 10 µm and it is impossible to fill the gap with the reflection wall resin, no reflection wall may be present on the electrode-formed surface. In this case, after mounting on the external substrate, an exposed surface of the electrode-formed surface may be protected by an underfill or the like.

In addition, the blending ratio between the silicon resin and titanium oxide is preferably about 5 to 30% in pigment volume concentration.

An invention according to a fourth aspect is a method for manufacturing the light emitting device according to the first aspect 1, the method including: an A1 step of attaching a fluorescent material-containing film to a dicing sheet and dividing the fluorescent material-containing film into a plurality of the fluorescent material-containing film pieces arranged in a matrix manner, using a thick dicing blade; an A2 step of transferring the plurality of the fluorescent material-containing film pieces arranged in a matrix manner, onto a worksheet; an A3 step of potting the silicon resin on each of the plurality of the fluorescent material-containing film pieces and die-bonding the semiconductor light emitting element thereon with the light extraction surface facing down, to form a double structure of the fluorescent material-containing film piece and the semiconductor light emitting element; an A4 step of attaching a band-shaped spacer for reflection wall onto the worksheet so as to surround a region where a plurality of the double structures arranged in a matrix manner are present, with a single passage left, and placing a top sheet on the spacer for reflection wall and the semiconductor light emitting element such that the top sheet is in close contact with an upper surface of the spacer for reflection wall and the bump mounting surface, to form a hermetic space which is hermitically sealed except for the single passage; an A5 step of injecting a resin for forming the reflection wall (hereinafter, referred to as a reflection wall resin) into the hermetic space formed in the A4 step through the single passage and curing the reflection wall resin to cover a surface other than the light exit surface of the double structure and the bump mounting surface with the reflection wall; and an A6 step of peeling the worksheet and the top sheet, attaching the double structures connected to each other via the reflection wall and formed into a plate shape onto a dicing sheet, and dicing a center between the adjacent double structures with a dicing blade thinner than the thick dicing blade, into the individual light emitting devices.

The light emitting device according to the first aspect is efficiently manufactured by using this manufacturing method.

This manufacturing method includes steps similar to those in Patent Literature 4, but is different from Patent Literature 4 in that the thickness of the reflection wall at the side surface of the fluorescent material-containing film piece, not at the side surface of the semiconductor light emitting element, is defined by dicing.

In an invention according to a fifth aspect based on the invention according to the fifth aspect, the fluorescent material-containing film is manufactured by a process including: a C1 step of attaching a closed band-shaped spacer for fluorescent material onto a thick release sheet such that the spacer for fluorescent material surrounds a space for forming the fluorescent material-containing film (hereinafter, referred to as a film forming space); a C2 step of potting a silicon resin in which fluorescent material powder is dispersed (hereinafter, referred to as a fluorescent material-containing silicon resin), in the film forming space with a feeding mechanism; a C3 step of filling the film forming space with the fluorescent material-containing silicon resin with a thickness equal to that of the spacer for fluorescent material; and a C4 step of placing a release sheet on the film forming space, sandwiching the film forming space between smooth and high rigid plates via the thick release sheet and the thin release sheet, and conducting curing with a certain amount of pressure applied.

The fluorescent material-containing film is efficiently manufactured with a simple tool by using this manufacturing method. The concentration of the fluorescent material powder is adjustable by composition adjustment, and the thickness of the fluorescent material-containing film is adjustable by the thickness of the spacer for fluorescent material. In addition, since sealing and curing are conducted with sandwiching between the smooth and high rigid plates to which pressure is applied by a spring or the like, flat surfaces are provided, and there is no entanglement of the worksheet, used in the fifth or sixth aspect, with a UV glue by an anchor effect. Thus, the detachability is improved.

An invention according to the sixth aspect is a method for manufacturing the light emitting device based on the invention according to the fifth aspect, wherein each of the worksheet, the spacer for reflection wall, the top sheet, and the spacer for fluorescent material is a base sheet which is made of a heat-resistant resin and one surface of which is coated with an ultraviolet-curable self-adhesive glue (hereinafter, referred to as a UV glue).

The above sheets are used in a step of curing the silicon resin, and thus need to have such heat resistance as to be resistant to the curing temperature. Thus, the base material of each sheet is preferably a heat-resistant resin such as PET resin. In addition, after being cured by ultraviolet light, the UV glue does not react with the silicon resin even at the curing temperature of the silicon resin, and the detachability thereof from the silicon resin after the curing is also favorable.

An invention according to a seventh aspect is a method for manufacturing the light emitting device based on the invention according to the sixth aspect, wherein the reflection wall resin is injected by a process including: a D1 step of irradiating a structure which has the single passage on the worksheet and forms the hermetic space formed in the A4 step, with ultraviolet light to cure the UV glue in the structure; a D2 step of placing the structure in a chamber which can be vacuumed, and vacuuming an inside of the chamber; a D3 step of potting the reflection wall resin such that the reflection wall resin blocks the single passage in the structure placed in the chamber; and a D4 step of causing an internal pressure of the chamber to gradually approach an atmospheric pressure to inject the reflection wall resin through the single passage into the hermetic space formed in the A4 step.

The invention according to the sixth aspect is efficiently practiced by using this manufacturing method. In addition, a facility used in this process is also configurable with a simple mechanism to pot the reflection wall resin using a simple vacuum chamber and the atmospheric pressure. It should be noted that the vacuuming in the D2 step is conducted to the 10⁻¹ Pa level, for example, by using a rotary pump.

An invention according to an eighth aspect is a method for manufacturing the light emitting device based on the invention according to any one of the fourth to seventh aspects, wherein an E1 step of irradiating the fluorescent material-containing film piece from below the fluorescent material-containing film piece using a light emitter which emits light having the same wavelength as that of the semiconductor light emitting element, and measuring chromaticity, color temperature, or the like of light converted by the fluorescent material-containing film piece with a detector located above the light emitter, is added between the A2 step and the A3 step.

When this step is added, it is possible to screen fluorescent material-containing film pieces, and it is possible to efficiently manufacture a light emitting device having intended chromaticity or color temperature at good yield.

An invention according to a ninth aspect is a method for manufacturing the light emitting device based on the invention according to the eighth aspect, wherein the silicon resin used in the A3 step is a silicon resin in which fluorescent material powder or a pigment for correcting chromaticity or color temperature is dispersed on the basis of measurement data in the E1 step.

When fluorescent material powder or a pigment having a concentration for correcting chromaticity is dispersed in the silicon resin used for bonding the semiconductor light emitting element and the fluorescent material-containing film piece on the basis of data of the measurement in the E1 step, it is possible to efficiently manufacture a light emitting device having intended chromaticity or color temperature at good yield.

An invention according to a tenth aspect is a method for manufacturing the light emitting device based on the invention according to any one of the sixth to ninth aspects, wherein the surface of the base sheet being the worksheet or the top sheet and made of the heat-resistant resin which surface is coated with the UV glue is roughened in a form of ground glass such that bonding strength with the glue is increased.

Regarding the bonding strength between the base sheet and the UV glue, since the surface of the base sheet is close to a mirror surface, the bonding strength with the cured UV glue is weak. Thus, after the reflection wall resin is cured, the cured UV glue may remain on the reflection wall or the fluorescent material-containing film piece when the worksheet or the top sheet is peeled off. It is possible to improve this by making the surface of the base sheet into the form of ground glass to increase the bonding strength between the base sheet and the UV glue by an anchor effect.

An invention according to an eleventh aspect is a light emitting device wherein
on a semiconductor light emitting element which emits blue light, purple light, or ultraviolet light, has two opposed principal surfaces one of which is a light extraction surface and another of which is an electrode-formed surface, and has a bump on the electrode-formed surface, a fluorescent material-containing film piece which has two opposed principal surfaces each of which is the same in size as or larger in size than the light extraction surface, one of which is a light entrance surface, and another of which is a light exit surface is overlaid such that the light extraction surface is opposed to the light entrance surface, and
an exposed surface other than the electrode-formed surface of the semiconductor light emitting element (including a surface of the bump) and the light exit surface of the fluorescent material-containing film piece (or the light exit surface of the fluorescent material-containing film piece and a bump mounting surface of the semiconductor light emitting element) and a portion, at the light exit surface side, of a side surface of the fluorescent material-containing film piece is covered with a reflection wall

This light emitting device is substantially the same as that of the first aspect, but is slightly subjected to structural constraints in order to simplify the manufacturing method. This is that a portion at which no reflection wall is present occurs at a part of the side surface of the fluorescent material-containing film piece, and thus there is the possibility that slight light leaks laterally. However, the above-described problems are almost solved similarly to the first aspect.

Here, for reference, in the case where no reflection wall is present at all at the side surface of the fluorescent material-containing film piece (but a reflection wall is present at the side surface of the semiconductor light emitting element), axial brightness is lower by not less than 10% than that in the case where there is a reflection wall as in the first aspect. In other words, a portion of the side surface of the fluorescent material-containing film piece at which portion no reflection wall is present needs to be as small as possible, and it is recognized that the reflection wall at the side surface of the fluorescent material-containing film piece is an important element for condensing light.

In addition, in the case of this structure, in the manufacturing method according to the fourth aspect, it is possible to omit a step corresponding to the A2 step (a transfer step).

An invention according to a twelfth aspect is a light emitting device wherein
on a semiconductor light emitting element which has a rectangular shape, has two opposed principal surfaces one of which is a light extraction surface and another of which is an electrode-formed surface, and has a bump on the electrode-formed surface, a transparent film piece which has a rectangular shape and has two opposed principal surfaces each of which is the same in size as or larger in size than the light extraction surface, one of which is a light entrance surface, and another of which is a light exit surface is overlaid such that the light extraction surface is opposed to the light entrance surface, and
an exposed surface other than the electrode-formed surface of the semiconductor light emitting element (including a surface of the bump) and the light exit surface of the transparent film piece or an exposed surface other than the light exit surface of the transparent film piece and a bump mounting surface of the semiconductor light emitting element is covered with a reflection wall.

When the structure of the present invention is applied to a semiconductor light emitting device which emits light of a single color in addition to a white light emitting device, it is possible to manufacture light emitting devices designed for three primary colors of light. These light emitting devices are chip-size packages with reflection walls and have a very small shape. Thus, it is possible to closely arrange single-color light emitting devices for red color, green color, and blue color, and it is possible to configure a white light emitting device having favorable color mixing, excellent color reproducibility, and high brightness. The structure of the present invention is usable for full-color backlights as well as for illumination.

### ADVANTAGEOUS EFFECTS OF THE INVENTION

The light emitting device according to the present invention is able to solve all the problems described above, with a chip-size package structure including a reflection wall.
Specifically, the following is achieved.

Since an expensive package substrate is not used, it is possible to reduce the cost.

A white light emitting element is provided in which the fluorescent material-containing film piece is overlaid on the light extraction surface of the semiconductor light emitting element, and it is possible to save the fluorescent material and to improve variations of chromaticity depending on a viewing angle due to a white point light emitter.

The surface other than the bump mounting surface of the semiconductor light emitting element and the light exit surface of the fluorescent material-containing film piece is covered with the reflection wall, and light traveling in a direction other than a direction toward the light exit surface (particularly, light traveling toward the side surface of the semiconductor light emitting element, light traveling toward the side surface of the fluorescent material-containing film piece, etc.) is dispersed and reflected by the reflection wall and condensed in a specific direction.

Moreover, the reflection wall is formed so as to be in close contact with a light source (namely, at the closest distance therefrom), and thus is able to most efficiently reflect and condense light in dispersion and reflection, whereby it is possible to provide high brightness.

Furthermore, since the semiconductor light emitting element is mounted at its bump mounting surface on the external substrate, heat is radiated from the semiconductor light emitting element directly to the bump, a solder, and the external substrate.

In addition, when the structure of the present invention is applied to a semiconductor light emitting device which emits light of a single color in addition to a white light emitting device, it is possible to manufacture light emitting devices designed for three primary colors of light. These light emitting devices are chip-size packages with reflection walls and have a very small shape. Thus, it is possible to closely arrange single-color light emitting devices for red color, green color, and blue color, and it is possible to configure a white light emitting device having favorable color mixing, excellent color reproducibility, and high brightness.

In addition, also in the manufacturing method, it is possible to screen fluorescent material-containing film pieces, and it is possible to efficiently manufacture a light emitting device having intended chromaticity or color temperature at good yield.

### BRIEF DESCRIPTION OF THE DRAWINGS

[FIG. 1] FIG. 1 is a diagram of a light emitting device according to a first embodiment of the present invention, FIG. 1(a) is a plan view as seen from above, FIG. 1(b) is a plan view as seen from below, and FIG. 1(c) is a cross-sectional view taken along a line A-A.
[FIG. 2] FIG. 2 is a diagram of a light emitting device according to a second embodiment of the present invention, FIG. 2(a) is a plan view as seen from above, FIG. 2(b) is a plan view as seen from below, and FIG. 2(c) is a cross-sectional view taken along a line B-B.
[FIG. 3] FIG. 3 is a diagram of a light emitting device according to a third embodiment of the present invention, FIG. 3(a) is a plan view, and FIG. 3(b) is a cross-sectional view.
[FIG. 4] FIG. 4 is a diagram of a light emitting device according to a fourth embodiment of the present invention, FIG. 4(a) is a plan view, and FIG. 4(b) is a cross-sectional view.
[FIG. 5] FIG. 5 is a manufacturing process diagram showing a method for manufacturing the light emitting device according to the first embodiment of the present invention.
[FIG. 6] FIG. 6 is a manufacturing process diagram showing a method for manufacturing the light emitting device according to the second embodiment of the present invention.
[FIG. 7] FIG. 7 is a manufacturing process diagram showing a method for manufacturing a fluorescent material-containing film according to a fifth embodiment of the present invention.
[FIG. 8] FIG. 8 is a diagram illustrating a workpiece used in a manufacturing method according to the present invention.
[FIG. 9] FIG. 9 is a diagram illustrating a resin injector used in the manufacturing method according to the present invention.
[FIG. 10] FIG. 10 is a diagram illustrating a reflection wall resin injection step used in the manufacturing method according to the present invention.
[FIG. 11] FIG. 11 is a diagram of a manufacturing process added to a manufacturing method according to a sixth embodiment of the present invention.
[FIG. 12] FIG. 12 is a diagram illustrating an example of improvement of a UV sheet used in the manufacturing method according to the present invention.
[FIG. 13] FIG. 13 is a diagram showing light emitting devices of conventional art, FIGS. 13(a) and 13(b) show a white light emitting element, and FIG. 13(c) shows a light emitting device.

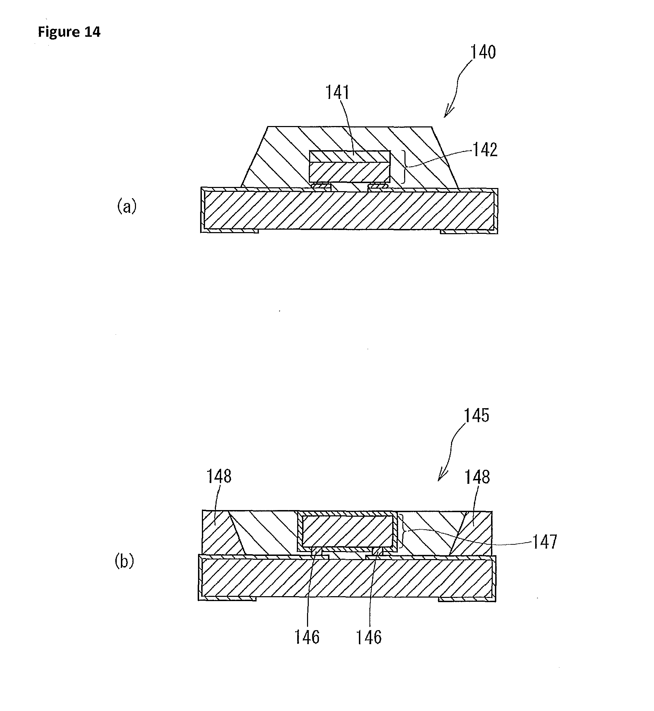

[FIG. 14] FIG. 14 is a cross-sectional view showing light emitting devices of conventional art.
[FIG. 15] FIG. 15 is a diagram showing chip-size packages of conventional art.
[FIG. 16] FIG. 16 is a diagram for illustrating heat radiation from light emitting devices.
[FIG. 17] FIG. 17 is a diagram of a light emitting device according to a seventh embodiment of the present invention, FIG. 17(a) is a plan view as seen from above, FIG. 17(b) is a plan view as seen from below, and FIG. 17(c) is a cross-sectional view taken along a line C-C.

### DESCRIPTION OF EMBODIMENTS

Hereinafter, embodiments of a light emitting device and a manufacturing method thereof according to the present invention will be described in detail in order from a first embodiment to a seventh embodiment with reference to the drawings.

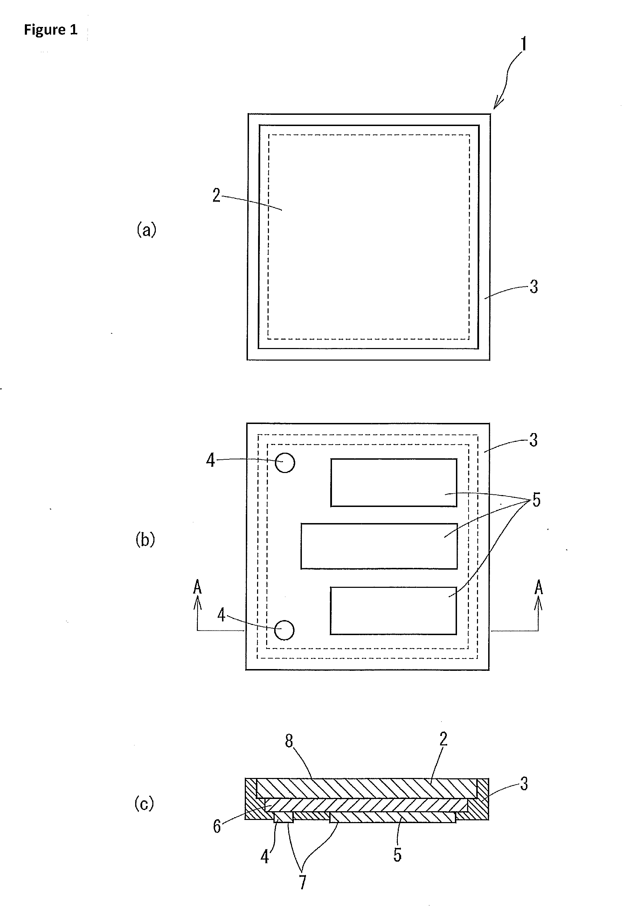

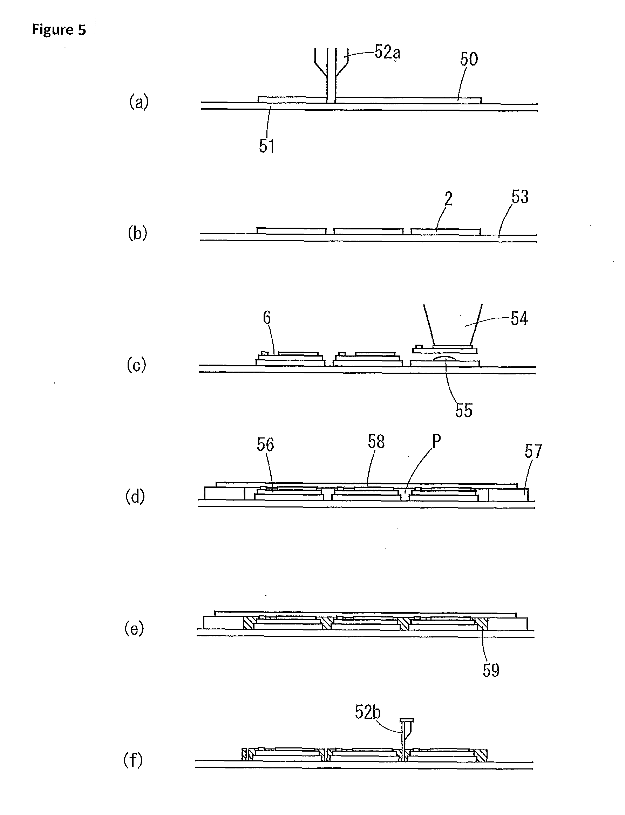

First, FIG. 1 shows a light emitting device according to the first embodiment. In addition, a manufacturing method thereof includes steps (a) to (f) as shown in FIG. 5 and is a manufacturing method in which a plurality of light emitting devices 1 are manufactured together.

In this case, as shown in FIG. 1, the light emitting device 1 includes a semiconductor light emitting element 6 in which bumps 4 and 5 having a thickness of 15 µm are formed on an n-side electrode and a p-side electrode of a blue LED element which emits blue light; a fluorescent material-containing film piece 2 which is integrated on a light extraction surface of the semiconductor light emitting element 6 by an adhesive and contains a fluorescent material; and a reflection wall 3 which covers an exposed surface other than: bump end portions 7 which are mounting surfaces of the semiconductor light emitting element 6; and a light exit surface 8 of the fluorescent material-containing film piece which is a light extraction surface.

The semiconductor light emitting element 6 is formed by laminating, as a GaN compound semiconductor film, a buffer layer, an n-type layer, a light emitting layer which emits blue light, and a p-type layer on a surface of a translucent crystal substrate (e.g., a sapphire substrate, an SIC substrate, a GaN substrate, etc.) in order from the substrate side, forming a p-side electrode on a surface of the p-type layer, selectively and partially etching the p-type layer and the light emitting layer, and forming an n-side electrode at the portion where the n-type layer is exposed. The p-side electrode and the n-side electrode are formed on substantially the same surface although a step of several µm is present therebetween. The surfaces of these electrodes are Au films. When it is in a wafer state, it is possible to conduct electroless plating on these electrodes in order of Pd, Ni, and Au (for surface protection), and bumps having a height of about 15 µm (preferably, 20 µm) are formed thereon. A most portion thereof having such a height is Ni.

The fluorescent material-containing film piece 2 is obtained by mixing powder of two types of fluorescent materials with a resin type silicone, molding the mixture into a film, curing the film, and dividing the film into rectangular pieces. One type of the fluorescent material is a fluorescent material excited by blue light to emit green light (e.g., Ca₃Sc₂Si₃O₁₂:Ce), and the other type of the fluorescent material is a fluorescent material excited by blue light to emit red light (e.g., CaAlSiN₃:Eu²⁺). The blending amounts thereof are adjusted such that the color temperature is about 5000 K which is close to that of a three band white fluorescent lamp. It is possible to select a color temperature by changing the blending amounts. As the resin type silicone, one is used which has a high refractive index (1.5 to 1.55), a Shore D hardness of 40 to 70 and preferably 60 to 70, and excellent transparency (e.g., the light transmittance for blue light having a wavelength of 450 nm is equal to or higher than 95% and preferably equal to or higher than 99% in the case where the resin thickness is 1 mm).

The reflection wall 3 is obtained by mixing titanium oxide fine powder having a particle diameter of 0.21 µm with a resin type silicone and curing the mixture. Titanium oxide has a high dielectric constant and a high optical reflectance, and thus is often used for a reflection wall. However, titanium oxide has characteristics as a photocatalyst, and thus is excited by ultraviolet light or blue light and acts on the ambient moisture or oxygen to produce an O₂H radical or an OH radical, resulting in deterioration of and change in color of the silicon resin. Thus, the color (white color) of the reflection wall surrounding the blue LED element is changed, and the brightness is decreased to 80% or lower in several tens of hours. Thus, as the titanium oxide fine particles to be used here, ones are used which are coated with silica or alumina or treated with siloxane in order to prevent the characteristics as a photocatalyst. In addition, the blending ratio to the silicon resin is about 5 to 30% in pigment volume concentration, and it is also necessary to prevent the reflectance from being decreased due to the effect of crowding. Moreover, as the resin type silicone, one is used which has a high refractive index (1.5 to 1.55), a Shore D hardness of 50 to 70 and preferably 60 to 70, and excellent transparency (e.g., the light transmittance for blue light having a wavelength of 450 nm is equal to or higher than 95% and preferably equal to or higher than 99% in the case where the resin thickness is 1 mm). Moreover, the thickness of the reflection wall is about 60 µm at the side surface of the fluorescent material-containing film piece 2, and is about 100 µm at the side surface of the semiconductor light emitting element 6 which is larger than that at the side surface of the fluorescent material-containing film piece 2. The thickness of the reflection wall on the electrode-formed surface is restricted by the bump height, and is smaller than 15 µm when the bump height is 15 µm. The bump height is preferably 20 µm, and in this case, the thickness of the reflection wall is smaller than 20 µm.

The resin type silicone that is used for the fluorescent material-containing film piece is used for bonding the semiconductor light emitting element 6 and the fluorescent material-containing film piece 2. The above fluorescent material for correcting chromaticity or color temperature may be mixed in the silicon resin in an appropriate amount.

The light emitting device is a white light emitting device of a chip-size package which does not use a package substrate, and is mounted at the bumps formed on the electrodes of the semiconductor light emitting element 6, on an external substrate via a solder. In addition, light directed in the lateral direction and the downward direction is dispersed and reflected by the reflection wall 3 and exits through the light exit surface 8.

Hereinafter, a method for manufacturing the light emitting device 1 will be described in order of steps in FIGS. 5(a) to 5(f).

First, in an A1 step (FIG. 5(a)), a fluorescent material-containing film 50 is attached to a dicing sheet 51, and then is fully cut into rectangular pieces with a dicer using a dicing blade 52a having a width of 150 to 200 µm. The size of each piece is made larger longitudinally and laterally than the size of the blue LED element by about 50 to 100 µm.

Next, in an A2 step (FIG. 5(b)), fluorescent material-containing film pieces 2 arranged on the dicing sheet 51 in a matrix manner are moved onto the above worksheet 53 by transfer. At that time, the transfer is conducted using a rubber roller. In the case with a UV glue, before the transfer, the dicing sheet is irradiated with ultraviolet light to cure the glue, so that the transfer is easily conducted.

Next, in an A3 step (FIG. 5(c)), using a die bonder 54, a silicon resin 55 for bonding is potted on each fluorescent material-containing film piece 2, and semiconductor light emitting elements 6 are placed thereon to form double structures 56. At that time, each semiconductor light emitting element 6 is self-aligned near the center of the fluorescent material-containing film piece 2 due to the surface tension of the silicon resin. Then, the worksheet is put in a curing oven and temporarily cured at a curing temperature of 120°C to 150°C for 10 minutes.

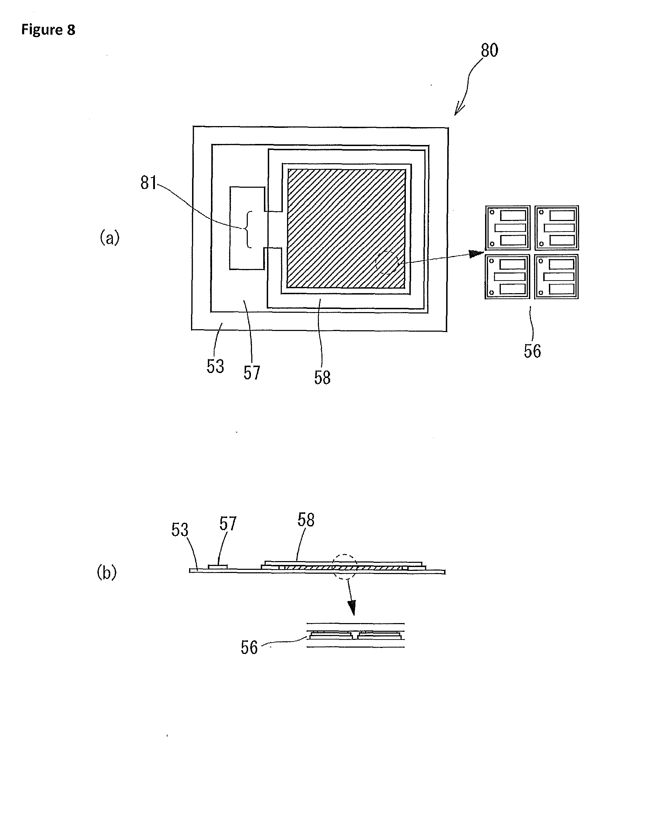

Next, in an A4 step (FIG. 5(d)), as shown in FIG. 8, a spacer 57 having such a shape as to surround a region on the worksheet 53 where the double structures 56 are present, with a single passage 81 left, is attached to the worksheet 53. The thickness of the spacer is preferably substantially the same as or slightly smaller than the height of each double structure 56. For example, when the height of each double structure 56 is 200 µm, the thickness of the spacer 57 is set to be 190 to 200 µm. In addition, a top sheet 58 is attached so as to be bonded to an upper surface of the spacer 57 and a bump mounting surface 7 of each semiconductor light emitting element 6, to cover the spacer 57 and each semiconductor light emitting element 6. By so doing, a hermetic space P is produced with the single passage 81 left, and a workpiece 80 is formed. Thereafter, the workpiece 80 is put into an ultraviolet irradiation apparatus, and the UV glue is cured by ultraviolet light.

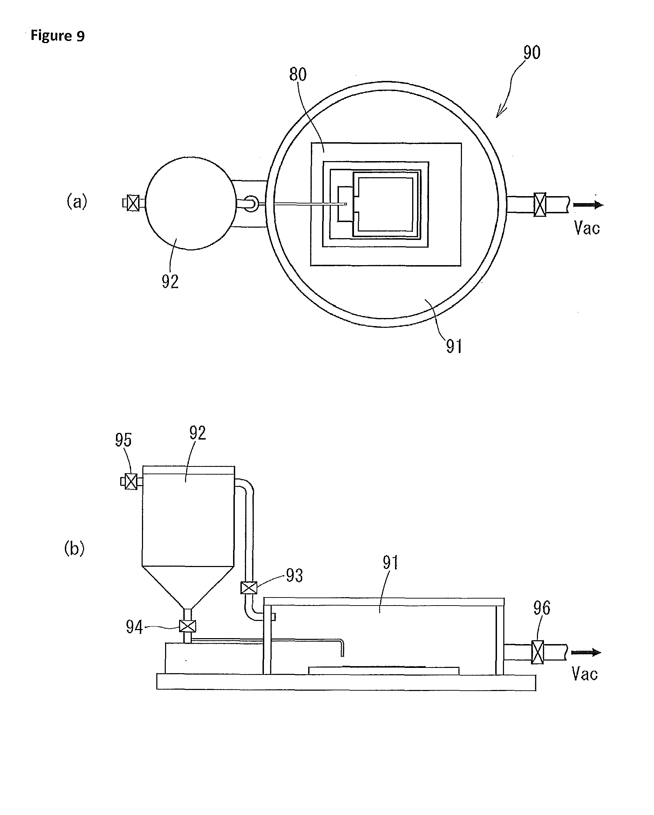

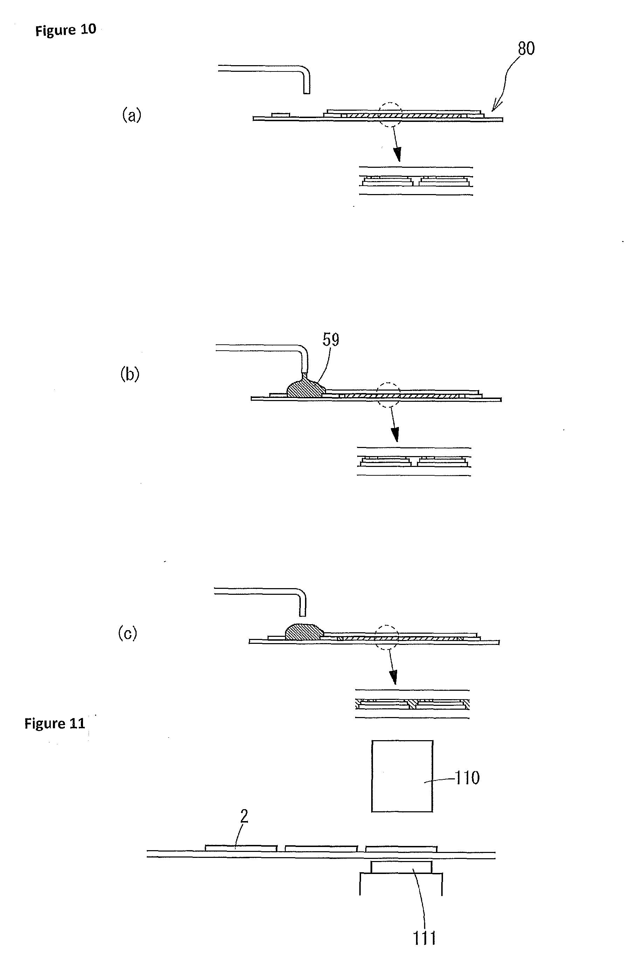

Next, in an A5 step (FIG. 5(e)), the workpiece 80 is put into a vacuum chamber 91 of a resin injector 90 shown in FIG. 9. A reflection wall resin 59 in which titanium oxide fine powder having a particle diameter of 0.21 µm is dispersed in a resin type silicone is contained in a container 92. First, in a state where valves 94, 95, and 96 are closed and a valve 93 is opened, a rotary vacuum pump is started up, the valve 96 is slowly opened, and the inside of the vacuum chamber 91 and the inside of the resin container 92 are slowly aspirated. At that time, the reflection wall resin 59 is deaerated. After the deaeration for 10 minutes, the valve 93 is closed, and the valve 95 is slowly opened. FIG. 10(a) shows a situation of the workpiece 80 within the vacuum chamber 91 in this state. Next, the valve 94 is slowly opened, and the reflection wall resin 59 is potted so as to block the single passage 81. After an appropriate amount is potted, the valve 94 is closed (FIG. 10(b)). Next, after 1 minute, the valve 96 is closed, the valve 93 is very slowly opened to permit air to enter the inside of the vacuum chamber 91 and gradually increase the pressure in the vacuum chamber 91. Due to the pressure difference, the resin 59 enters into gaps in the hermetic space P (FIG. 10(c)). After the resin 59 is injected into the hermetic space P, the workpiece 80 is taken out when the internal pressure of the vacuum chamber 91 becomes equal to the atmospheric pressure. The workpiece 80 is sandwiched between stainless steel plates (hereinafter, referred to as SUS plates), an appropriate amount of pressure is applied to the SUS plates by springs, and the workpiece 80 is cured in a curing oven (curing temperature: 120°C to 150°C, 1 hour).

Next, in an A6 step (FIG. 5(f)), the top sheet 58, the spacer 57, and the worksheet 53 are peeled off from the workpiece 80, and the workpiece in which the double structures are connected to each other via the reflection wall resin in a plate shape is attached to a dicing sheet and divided at the center between the adjacent double structures with a dicer using a dicing blade 52b having a width of 30 µm. By so doing, a light emitting device 1 is completed.

As described above, according to the present embodiment (first embodiment), it is possible to provide a chip-size package structure in which a package substrate having a high occupancy of the material cost is eliminated and which also has a function to condense light, emitted by a white light emitting element, in a specific direction with low loss in the form of a reflection wall, and it is possible to manufacture a light emitting device for illumination which has improved characteristics (high brightness and favorable heat radiation) and is inexpensive.

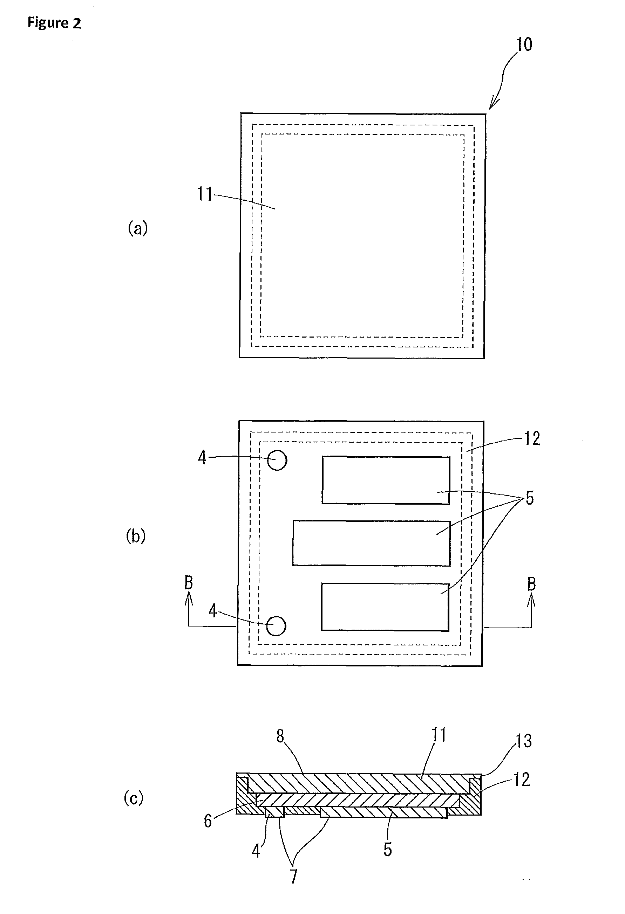

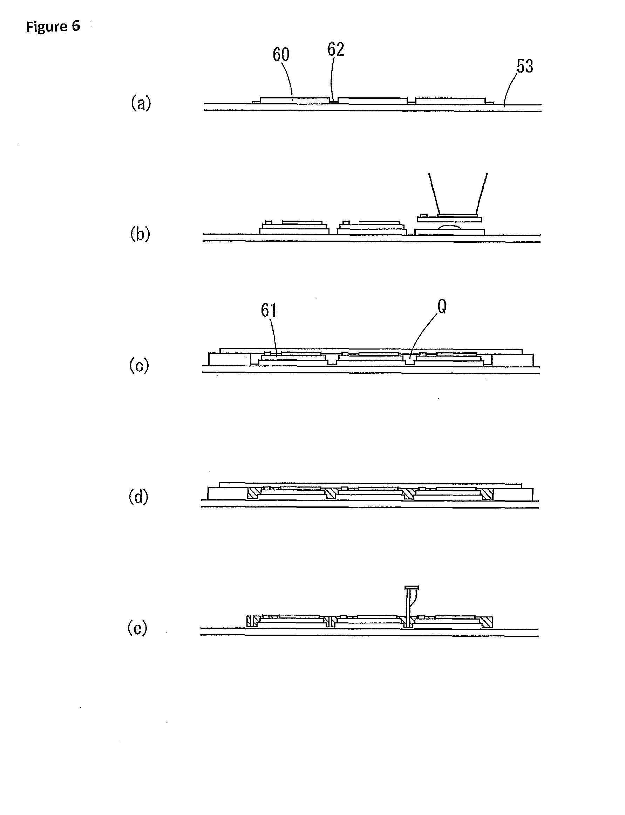

Next, FIG. 2 shows a light emitting device according to a second embodiment. In addition, FIG. 6 shows a manufacturing method thereof.

In this case, as shown in FIG. 2, the light emitting device 10 is almost the same as that in the first embodiment, but is different therefrom in being slightly subjected to structural constraints in order to simplify the manufacturing method. This is that a portion 13 at which no reflection wall is present occurs at a part of the side surface of a fluorescent material-containing film piece. Thus, there is the possibility that slight light leaks laterally, but the above-described problems are almost solved similarly to the light emitting device 1 according to the first embodiment.

The method for manufacturing the light emitting device 10 includes steps in FIGS. 6(a) to 6(e). Most of the steps are the same as those of the manufacturing method in FIG. 5 and the description of the same steps is omitted, but a different step is the step in FIG. 6(a).

In FIG. 6(a), a fluorescent material-containing film 50 is attached directly to a worksheet 53. Then, the fluorescent material-containing film 50 is cut with a dicer using a dicing blade 52a having a width of 150 to 200 µm so as to form cut grooves thereon with connection portions 62 of the fluorescent material-containing film 50 left, not fully cut into rectangular pieces. By so doing, fluorescent material-containing film piece-like projections 60 are formed. The size of each projection 60 is made larger longitudinally and laterally than the size of the blue LED element by about 50 to 100 µm. The purpose of this step is that it is possible to omit the A2 step which is the transfer step in FIG. 5(b). In the A1 step in which the fluorescent material-containing film 50 is fully cut with the dicer, the sheet is also cut, and thus the necessity to replace the sheet arises and the transfer step is required. In addition, the connection portions 62 are preferably made as thin as possible. Moreover, it is possible to produce such projections with a compression molding machine, not with the dicer.

Hereinafter, the step in FIG. 6(b) is the same as the A3 step when each fluorescent material-containing film piece 2 is replaced with each fluorescent material-containing film piece-like projection 60 and each double structure 56 is replaced with each double structure projection 61.

Similarly, the step in FIG. 6(c) is the same as the A4 step; the step in FIG. 6(d) is the same as the A5 step; and the step in FIG. 6(e) is the same as the A6 step. It should be noted that the hermetic space Q in FIG. 6(c) corresponds to the hermetic space P in the A4 step (FIG. 5(d)).

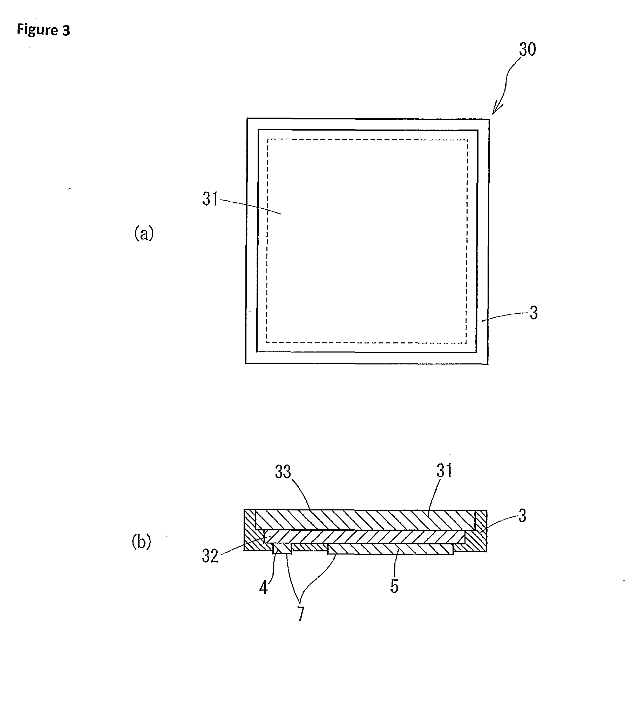

Next, FIG. 3 shows a light emitting device according to a third embodiment.

In this case, the light emitting device 30 uses a transparent film piece 31 instead of the fluorescent material-containing film piece 2. Thus, the color of light emitted by a semiconductor light emitting element 32 becomes the color of light emitted by the light emitting device 30 as it is.

A manufacturing method thereof is the same as that in the first embodiment, and it suffices that the fluorescent material-containing film is replaced with a transparent film.

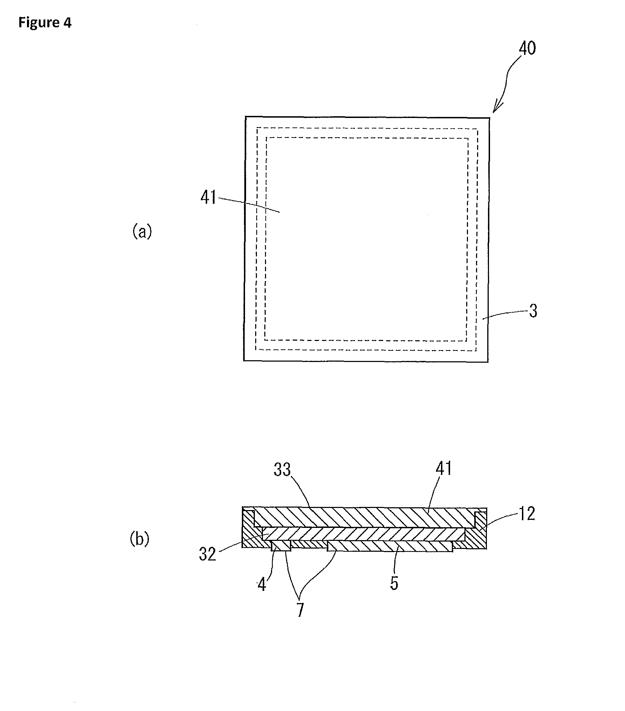

Next, FIG. 4 shows a light emitting device according to a fourth embodiment.

In this case, in the light emitting device 40, the shape of a transparent film piece 41 is different from that in the third embodiment, and no reflection wall is present at a part of a side surface. Therefore, light leaks laterally therethrough, but it is possible to produce a light emitting device having different light distribution by utilizing this.

A manufacturing method thereof is the same as that in the second embodiment, and it suffices that the fluorescent material-containing film is replaced with a transparent film. The side surface shape of the transparent film piece 41 is freely changeable. Thus, the shape of a reflection wall 12 is also adjustable, and the light distribution is also adjustable.

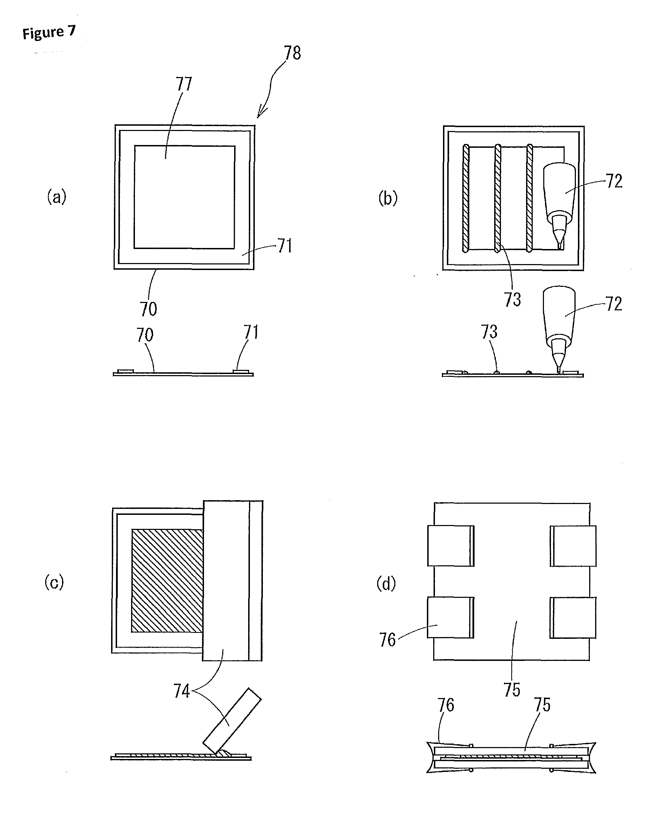

Next, a method for manufacturing a fluorescent material-containing film will be described as a fifth embodiment in order of steps (a) to (d) in FIG. 7.

First, in a C1 step (a), a closed band-shaped spacer 71 for fluorescent material is attached onto a release sheet 70 having a thickness of 0.1 mm so as to surround a film forming space 77, to make a workpiece 78 for fluorescent material film. The thickness of the spacer 71 is about 100 µm.

Next, in a C2 step (b), appropriate amounts of powder of two types of fluorescent materials (one type is a fluorescent material which emits green light from blue light, and the other type is a fluorescent material which emits red light from blue light) are measured, and sufficiently mixed and dispersed in a resin type silicone with a rotation/revolution mixer. Thereafter, this fluorescent material-containing silicon resin is deaerated in vacuum, put into a syringe 72, and potted in streaks in the film forming space 77.

Next, in a C3 step (c), a metallic squeegee 74 is moved parallel along an upper surface of the spacer 71 for fluorescent material such that the streaked fluorescent material-containing silicon resin 73 spreads over the entire film forming space 77 with a thickness equal to that of the spacer 71.

Next, in a C4 step (d), a thin release sheet is put over an upper surface of the workpiece 78 for fluorescent material film, the workpiece 78 is sandwiched between SUS plates 75, an appropriate amount of pressure is applied thereto by springs 76, and the workpiece 78 is cured in a curing oven under the conditions of 150°C and 1 hour. Temperature rise and temperature fall of the curing oven are conducted according to an optimum program for resin curing.

It is possible to manufacture the fluorescent material-containing film 50 by the above method. Since pressing and curing are conducted in a state of being sandwiched between the SUS plates, the surface of the film 50 manufactured by this method becomes a mirror surface having less recesses and projections. In the method for manufacturing the light emitting device, detachability from the worksheet 53 is good, and it is possible to prevent a problem that the UV glue remains on the light exit surface 8 of the light emitting device.

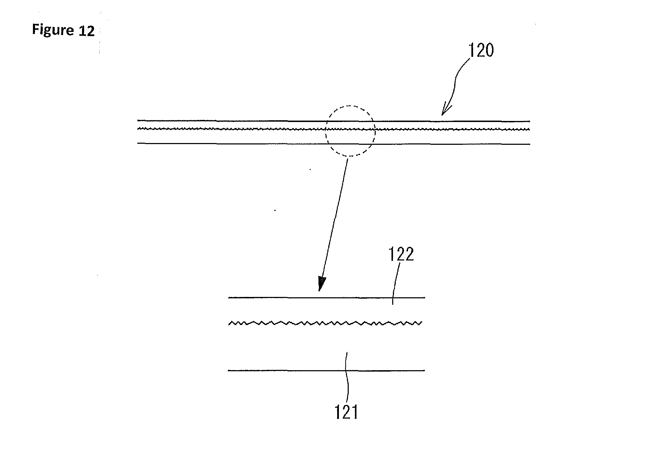

In addition, it is possible to completely solve this problem by using a UV sheet in which, as shown in FIG. 12, a surface of a base sheet 121 made of a PET resin and used for the worksheet 53 or the top sheet 58 which surface is coated with a UV glue 122 is roughened in the form of ground glass such that bonding strength with the UV glue 122 is increased.

Next, an E1 step shown in FIG. 11 and added to the method for manufacturing the light emitting device in order to improve yield will be described as a sixth embodiment.

The E1 step is a step conducted between the A2 step and the A3 step in the first embodiment, each fluorescent material-containing film piece 2 is irradiated from below the fluorescent material-containing film piece 2 using a light emitter 111 which emits light having substantially the same wavelength as that of the semiconductor light emitting element 6, and chromaticity, color temperature, or the like of light converted by the fluorescent material-containing film piece 2 is measured with a detector 110 located above the light emitter 111.

Since the E1 step is added, it is possible to conduct screening of the fluorescent material-containing film pieces 2 (good/bad determination) or correct the chromaticity or the color temperature by dispersing fluorescent material powder in the silicon resin 55 for bonding in the A3 step, on the basis of data obtained in the E1 step. As a result, the chromaticity yield is improved.

Also in the second embodiment, when the E1 step is conducted between a B1 step and a B2 step, the same advantageous effects are provided.

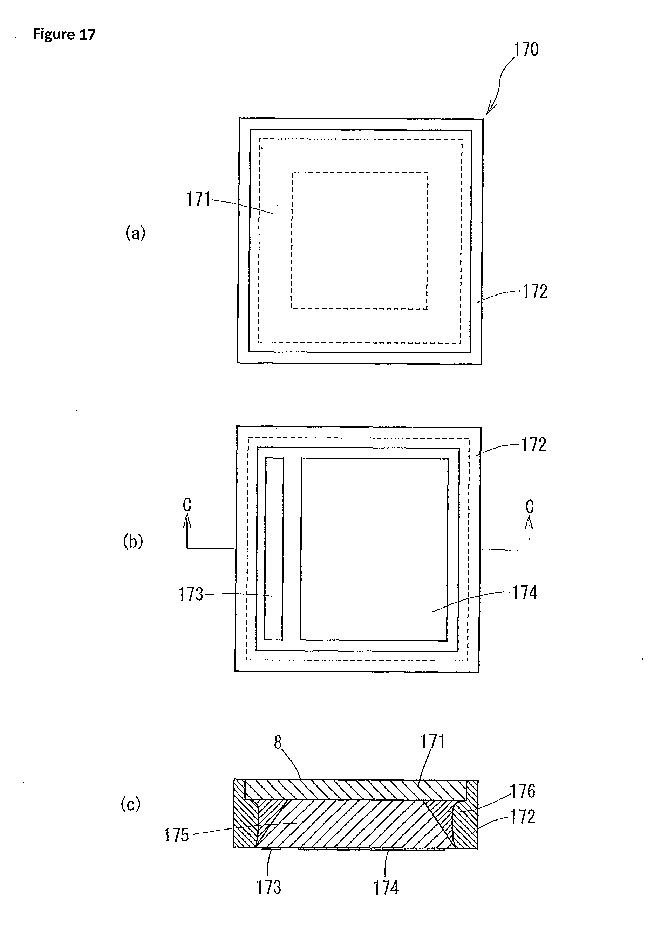

Next, FIG. 17 shows a light emitting device according to the seventh embodiment.

A semiconductor light emitting element 175 used in the light emitting device 170 has a trapezoidal shape in which a light extraction surface is smaller than an electrode-formed surface, its side surface is tilted, and light extraction from this surface is also taken into consideration. In addition, an n-electrode 174 (which occupies a large portion of the electrode-formed surface) and a p-electrode 173 on the electrode-formed surface are formed with Au-Sn layers having a thickness of 3 µm for thermal welding. It is important to assist in light extraction from the side surface by potting a silicon resin 176 for bonding a fluorescent material-containing film piece 171 and the semiconductor light emitting element 175 in a slightly large amount so as to form a transparent layer 176 on a tilt portion of the side surface of the semiconductor light emitting element 175 by surface tension. A reflection wall 172 is formed at the outer side of the silicon resin 176.

In addition, since the Au-Sn platings on the electrodes have a small thickness of 3 µm, the reflection wall is not fully formed in the gap on the electrode-formed surface (there is a case where no reflection wall is formed, or a case where a reflection wall is partially formed at an end). However, since the electrode whose reflectance is taken into consideration occupies a large portion of the electrode-formed surface, the problems are sufficiently solved. It should be noted that a portion of the electrode-formed surface which is exposed after mounting is preferably protected by an underfill or the like.

### DESCRIPTION OF THE REFERENCE CHARACTERS

- 1, 10, 30, 40, 170: light emitting device
- 2, 11, 171: fluorescent material-containing film piece
- 3, 12, 172: reflection wall
- 4, 5: bump
- 6, 32, 175: semiconductor light emitting element
- 7: bump mounting surface
- 8, 33: light exit surface
- 13: portion at which no reflection wall is present
- 31, 41: transparent film piece
- 51: dicing sheet
- 52a, 52b: dicing blade
- 53: worksheet
- 54: die bonder
- 55, 176: silicon resin for bonding
- 56: double structure
- 57: spacer for reflection wall
- 58: top sheet
- 59: reflection wall resin
- 60: fluorescent material-containing film piece-like projection
- 61: double structure projection
- 62: connection portion
- 70: release sheet
- 71: spacer for fluorescent material
- 72: syringe
- 73: fluorescent material-containing silicon resin
- 74: squeegee
- 75: SUS plate
- 76: spring
- 80: workpiece
- 81: single passage
- 90: resin injector
- 91: vacuum chamber
- 92: resin container
- 93, 94, 95, 96: valve
- 110: detector
- 111: light emitter
- 120: UV sheet
- 121: base material
- 122: UV glue
- 173, 174: electrode
- P, Q: hermetic space

## Claims

1. A light emitting device wherein
on a semiconductor light emitting element which emits blue light, purple light, or ultraviolet light, has two opposed principal surfaces one of which is a light extraction surface and another of which is an electrode-formed surface, and has a bump on the electrode-formed surface, a fluorescent material-containing film piece which has two opposed principal surfaces each of which is the same in size as or larger in size than the light extraction surface, one of which is a light entrance surface, and another of which is a light exit surface is overlaid such that the light extraction surface is opposed to the light entrance surface, and
an exposed surface other than the electrode-formed surface of the semiconductor light emitting element (including a surface of the bump) and the light exit surface of the fluorescent material-containing film piece or an exposed surface other than the light exit surface of the fluorescent material-containing film piece and a bump mounting surface of the bump at which the semiconductor light emitting element is mounted on an external substrate is covered with a reflection wall.

2. The light emitting device according to claim 1, wherein the semiconductor light emitting element and the fluorescent material-containing film piece are bonded to each other by a silicon resin or a silicon resin which contains a fluorescent material or a pigment for correcting chromaticity or color temperature.

3. The light emitting device according to claim 1 or 2, wherein a material of the fluorescent material-containing film piece is a material obtained by dispersing powder of several types of fluorescent materials in a silicon resin, and a material of the reflection wall is a material obtained by dispersing titanium oxide fine powder in a silicon resin.

4. A method for manufacturing the light emitting device according to claim 1, the method comprising:
an A1 step of attaching a fluorescent material-containing film to a dicing sheet and dividing the fluorescent material-containing film into a plurality of the fluorescent material-containing film pieces arranged in a matrix manner, using a thick dicing blade;
an A2 step of transferring the plurality of the fluorescent material-containing film pieces arranged in a matrix manner, onto a worksheet;
an A3 step of potting the silicon resin on each of the plurality of the fluorescent material-containing film pieces and die-bonding the semiconductor light emitting element thereon with the light extraction surface facing down, to form a double structure of the fluorescent material-containing film piece and the semiconductor light emitting element;
an A4 step of attaching a band-shaped spacer for reflection wall onto the worksheet so as to surround a region where a plurality of the double structures arranged in a matrix manner are present, with a single passage left, and placing a top sheet on the spacer for reflection wall and the semiconductor light emitting element such that the top sheet is in close contact with an upper surface of the spacer for reflection wall and the bump mounting surface of the bump at which the semiconductor light emitting element is mounted on the external substrate, to form a hermetic space which is hermitically sealed except for the single passage;
an A5 step of injecting a reflection wall resin for forming the reflection wall into the hermetic space formed in the A4 step through the single passage and curing the reflection wall resin to cover a surface other than the light exit surface of the double structure and the bump mounting surface with the reflection wall; and
an A6 step of peeling the worksheet and the top sheet, attaching the double structures connected to each other via the reflection wall and formed into a plate shape onto a dicing sheet, and dicing a center between the adjacent double structures with a dicing blade thinner than the thick dicing blade, into the individual light emitting devices.

5. The method for manufacturing the light emitting device according to claim 4, wherein the fluorescent material-containing film is manufactured by a process comprising:
a C1 step of attaching a closed band-shaped spacer for fluorescent material onto a thick release sheet such that the spacer for fluorescent material surrounds a film forming space for forming the fluorescent material-containing film;
a C2 step of potting a fluorescent material-containing silicon resin in which fluorescent material powder is dispersed, in the film forming space with a feeding mechanism;
a C3 step of filling the film forming space with the fluorescent material-containing silicon resin with a thickness equal to that of the spacer for fluorescent material; and
a C4 step of placing a release sheet on the film forming space, sandwiching the film forming space between smooth and high rigid plates via the thick release sheet and the thin release sheet, and conducting curing with a certain amount of pressure applied.

6. The method for manufacturing the light emitting device according to claim 5, wherein each of the worksheet, the spacer for reflection wall, the top sheet, and the spacer for fluorescent material is a base sheet which is made of a heat-resistant resin and one surface of which is coated with an ultraviolet-curable self-adhesive glue.

7. The method for manufacturing the light emitting device according to claim 6, wherein the reflection wall resin is injected by a process comprising:
a D1 step of irradiating a structure which has the single passage on the worksheet and forms the hermetic space formed in the A4 step, with ultraviolet light to cure the ultraviolet-curable self-adhesive glue in the structure;
a D2 step of placing the structure in a chamber which can be vacuumed, and vacuuming an inside of the chamber;
a D3 step of potting the reflection wall resin such that the reflection wall resin blocks the single passage in the structure placed in the chamber; and
a D4 step of causing an internal pressure of the chamber to gradually approach an atmospheric pressure to inject the reflection wall resin through the single passage into the hermetic space formed in the A4 step.

8. The method for manufacturing the light emitting device according to any one of claims 4 to 7, wherein an E1 step of irradiating the fluorescent material-containing film piece from below the fluorescent material-containing film piece using a light emitter which emits light having the same wavelength as that of the semiconductor light emitting element, and measuring chromaticity, color temperature, or the like of light converted by the fluorescent material-containing film piece with a detector located above the light emitter, is added between the A2 step and the A3 step.

9. The method for manufacturing the light emitting device according to claim 8, wherein the silicon resin used in the A3 step is a silicon resin in which fluorescent material powder or a pigment for correcting chromaticity or color temperature is dispersed on the basis of measurement data in the E1 step.

10. The method for manufacturing the light emitting device according to any one of claims 6 to 9, wherein the surface of the base sheet being the worksheet or the top sheet and made of the heat-resistant resin which surface is coated with the ultraviolet-curable self-adhesive glue is roughened in a form of ground glass such that bonding strength with the glue is increased.

11. A light emitting device wherein
on a semiconductor light emitting element which emits blue light, purple light, or ultraviolet light, has two opposed principal surfaces one of which is a light extraction surface and another of which is an electrode-formed surface, and has a bump on the electrode-formed surface, a fluorescent material-containing film piece which has two opposed principal surfaces each of which is the same in size as or larger in size than the light extraction surface, one of which is a light entrance surface, and another of which is a light exit surface is overlaid such that the light extraction surface is opposed to the light entrance surface, and
an exposed surface other than the electrode-formed surface of the semiconductor light emitting element (including a surface of the bump) and the light exit surface of the fluorescent material-containing film piece (or the light exit surface of the fluorescent material-containing film piece and a bump mounting surface of the bump at which the semiconductor light emitting element is mounted on an external substrate) and a portion, at the light exit surface side, of a side surface of the fluorescent material-containing film piece is covered with a reflection wall.

12. A light emitting device wherein
on a semiconductor light emitting element which has two opposed principal surfaces one of which is a light extraction surface and another of which is an electrode-formed surface and has a bump on the electrode-formed surface, a transparent film piece which has two opposed principal surfaces each of which is the same in size as or larger in size than the light extraction surface, one of which is a light entrance surface, and another of which is a light exit surface is overlaid such that the light extraction surface is opposed to the light entrance surface, and
an exposed surface other than the electrode-formed surface of the semiconductor light emitting element (including a surface of the bump) and the light exit surface of the transparent film piece or an exposed surface other than the light exit surface of the transparent film piece and a bump mounting surface of the bump at which the semiconductor light emitting element is mounted on an external substrate is covered with a reflection wall.
